# EUROPEAN PATENT APPLICATION

(11) **EP 1 775 775 A1**
(43) Date of publication of application: **18.04.2007**
(21) Application number: 05745932.3
(22) Date of filing: 31.05.2005
(51) Int. Cl.: H01L 29/786, H01L 21/336

(54) **FIELD EFFECT TRANSISTOR AND MANUFACTURING METHOD THEREOF**

(30) Priority: 01.06.2004 JP 2004162677
(71) Applicant: Yamanashi TLO Co., Ltd., Kofu-shi, Yamanashi 400-8510 (JP)
(72) Inventor: NAKAGAWA, Kiyokazu, Kofu-shi, Yamanashi 400-0016 (JP); ARIMOTO, Keisuke, Kai-shi, Yamanashi 400-0126 (JP); MITSUI, Minoru, Kofu-shi, Yamanashi 400-0016 (JP)
(74) Representative: Käck, Jürgen
(86) International application number: PCT/JP2005/010303
(87) International publication number: WO 2005/119788

(57) **Abstract**

There is provided a method for manufacturing an FET on a glass substrate at a low temperature. A polysilicon layer (2) is formed on the glass substrate (1). Germanium layers (11, 12) are formed at the area on the polysilicon layer to become a source and a drain. Ions to become a dopant are implanted at least into the germanium layers. After this, anneal is performed so as to diffuse the implanted dopant in the polysilicon layer to form a source region S and a drain region D and crystallize the germanium layer. Alternatively, the dopant in a dose not making the polysilicon layer amorphous is also implanted into the polysilicon layer and anneal is performed to crystallize the germanium. Anneal may be performed at the temperature about 500 degrees C.

## Description

### Technical Field

This invention relates to a field-effect transistor (FET) provided on a glass substrate, and to a method of manufacturing this FET.

### Background Art

An example of a field-effect transistor (FET) provided on a glass substrate is a thin-film transistor (TFT) in a liquid crystal display device, in which a pair of insulating glass substrates are filled with liquid crystal and a number of TFTs are placed in a matrix array on one of the glass substrates and function as switching elements. Since the strain point (strain-point temperature) (the temperature at which glass begins to strain) of a glass substrate is a comparatively low temperature (e.g., 500°C), techniques whereby an FET can be manufactured at low temperatures are being sought.

A variety of TFT manufacturing techniques have been developed.

For example, a technique relating to a thin-film transistor described in Japanese Patent Application Laid-Open No. 61-284965 is as follows: In order to operate a transistor, not only a channel region but also a low-resistance source region and drain region to which an impurity has been added must be formed. According to the method described in this publication, a-Si₁₋ₓGeₓ to which an impurity has been added is deposited on the entire surface of a layer of a-Si. Thereafter, by utilizing the fact that the etching rate of a-Si₁-ₓGeₓ is higher than that of a-Si, the a-Si₁₋ₓGeₓ on the channel region of a-Si adjacent to the gate region is selectively removed, thereby fabricating a transistor.

A method of manufacturing a silicon thin-film transistor disclosed in Japanese Patent Application Laid-Open No. 3-165067 deposits polycrystalline Ge at a temperature of 530°C on a portion of a polycrystalline Si film that will become a source-drain region, vapor-deposits an impurity such as In on this portion, and causes the impurity to diffuse into the Ge by annealing for 30 minutes at 500°C, thereby forming source and drain regions.

A method of manufacturing an insulated-gate transistor described in Japanese Patent Application Laid-Open No. 2000-286420 selectively deposits SiGe on the source region of an SOI-MOS transistor having Si as a channel, thereby so arranging it that a kink phenomenon that appears in the current-voltage characteristic will not occur. This is a transistor comprising a single crystal and employs a high-temperature process in manufacture.

None of the techniques mentioned above manufactures a field-effect transistor at comparatively low temperatures in the neighborhood of 500°C.

### Disclosure of the Invention

An object of the present invention is to provide a method of manufacturing a field-effect transistor in a comparatively low-temperature environment as well as a field-effect transistor manufactured by this method of manufacture.

A first method of manufacturing a field-effect transistor according to the present invention comprises forming a polycrystalline silicon layer on a glass substrate; forming germanium layers on the polycrystalline silicon layer in regions that are to become a source and a drain; implanting ions, which serve as a dopant, at least into the germanium layers; and subsequently causing the implanted dopant to diffuse into the polycrystalline silicon layer by annealing, thereby forming source and drain regions and crystallizing the germanium layers.

The annealing is performed in the neighborhood of 500°C, preferably below 505°C and, more preferably, below 500°C.

A source electrode and a drain electrode are formed on the germanium layers that have been formed in the source and drain regions, and a gate electrode is provided on the polycrystalline silicon layer (on the region that will be the channel) between the source and drain regions via an insulating film, thereby completing a field-effect transistor on the glass substrate.

A field-effect transistor according to the present invention has a polycrystalline silicon layer formed on a glass substrate; germanium layers formed on the polycrystalline silicon layer in regions that are to become a source and a drain; and source and drain regions formed by thermally diffusing a dopant, which has been implanted at least into the germanium layers, into the polycrystalline silicon layer.

A source electrode and a drain electrode are formed on the germanium layers in the source region and drain region, respectively, and a gate electrode is formed via an insulating film on the polycrystalline silicon layer in a portion that is to be a channel between the source region and the drain region.

The dopant may be implanted only in the germanium layers or it may be so arranged that the dopant passes through the germanium layers and reaches the underlying polycrystalline silicon layer (in which case the dosage is not enough to render the polycrystalline silicon layer amorphous).

By applying annealing (heating) after the dopant is implanted, the implanted dopant thermally diffuses into the polycrystalline silicon layer, the dopant is activated and the germanium layers become polycrystalline. As a result, the resistivity of the germanium layers and of the source and drain regions formed by the diffusion of the dopant is lowered by a wide margin, and hence the functioning of the device as a field-effect transistor can be assured. Since annealing at a comparatively low temperature (e.g., in the neighborhood of 500°C, or below 505°C, or below 500°C) is sufficient, a field-effect transistor can be fabricated on a glass substrate at comparatively low temperatures.

A second method of manufacturing a field-effect transistor according to the present invention comprises forming a polycrystalline silicon layer on a glass substrate; forming germanium layers selectively on the polycrystalline silicon layer in regions that are to become a source and a drain; implanting ions, which serve as a dopant, into the germanium layers and implanting ions, so as to reach the polycrystalline silicon layer, at a dosage less than a critical dosage that will render the polycrystalline silicon layer amorphous; and subsequently crystallizing the germanium layers by annealing.

Whichever of the implantation of dopant into the germanium layers or implantation of dopant into the polycrystalline silicon layer is performed first does not matter, and it can also be so arranged that desired dopant distributions in the germanium layers and polycrystalline silicon layer are obtained by a single dopant implantation rather than by dividing implantation into two operations.

A source electrode and a drain electrode are formed on the germanium layers that have been formed in regions that are to become the source and drain, and a gate electrode is provided on the polycrystalline silicon layer (on the region that will be the channel) between the source and drain regions via an insulating film, thereby completing a field-effect transistor on the glass substrate.

By applying annealing after the dopant is implanted in the germanium layers, the dopant in the germanium layers is activated and the germanium layers become polycrystalline. Further, since the dopant is injected into the polycrystalline silicon layer to such a degree that the polycrystalline silicon layer, inclusive of the boundary with the germanium layers, will not be rendered amorphous (the effect of injection by thermal diffusion is not excluded), the polycrystalline state is maintained. Thus, the resistivity of the germanium layers and of the portions within the polycrystalline silicon layer that contact the germanium layers is reduced by a wide margin and the regions operate as source and drain regions. Annealing at a comparatively low temperature (e.g., in the neighborhood of 500°C, or below 505°C, or below 500°C) is sufficient.

Thus, in both the first and second manufacturing methods, the present invention utilizes the fact that solid-phase growth (epitaxy) of germanium occurs at a temperature in the neighborhood of 500°C (below 505°C, or below 500°C).

In both the first and second manufacturing methods, it is preferred that germanium layers be vapor-deposited and ion implantation be performed upon forming a mask on the polycrystalline silicon layer except in the regions that are to be the source and drain, after which the mask is removed.

A single mask can be utilized for both vapor deposition of the germanium layers and ion implantation.

If a field-effect transistor that has been manufactured by the first and second manufacturing methods is expressed in general terms, the field-effect transistor has a polycrystalline silicon layer formed on a glass substrate; and germanium layers formed on the polycrystalline silicon layer in regions that are to become a source and a drain; wherein a source region and a drain region are formed by distributing a dopant in the germanium layers and at portions where the polycrystalline silicon layer contacts the germanium layers, and the germanium layers in which the dopant is distributed are formed by ion implantation of the dopant and crystallization by subsequent annealing.

In one embodiment, the distribution of dopant within the polycrystalline silicon layer is based upon the fact that dopant implanted at least into the germanium layers is thermally diffused into the polycrystalline silicon layer (overlap with implanted dopant described next is not excluded).

In another embodiment, the distribution of dopant within the polycrystalline silicon layer is based upon ion implantation at a dosage of such a degree that the polycrystalline silicon layer will not be rendered amorphous (the contribution of thermal diffusion to distribution of dopant is not excluded).

### Brief Description of the Drawings

Fig. 1 is a sectional view illustrating a step of forming a polycrystalline Si layer on a glass substrate;
Fig. 2 is a sectional view illustrating a step of forming a mask on the polycrystalline Si layer;
Fig. 3 is a sectional view illustrating a step of forming a Ge layer on the polycrystalline Si layer;
Fig. 4 is a sectional view illustrating a step of implanting ions of a dopant in the Ge layer;
Fig. 5 is a sectional view illustrating a step of removing the mask and thermally diffusing dopant by annealing;
Fig. 6 is a sectional view illustrating a step of forming an insulating film on a region that is to be a channel;
Fig. 7 is a sectional view illustrating a step of finally forming a source electrode, a drain electrode and a gate electrode; and
Fig. 8 is a profile diagram illustrating depth-direction distributions of dopant in first and second embodiments.

### Best Mode for Carrying Out the Invention

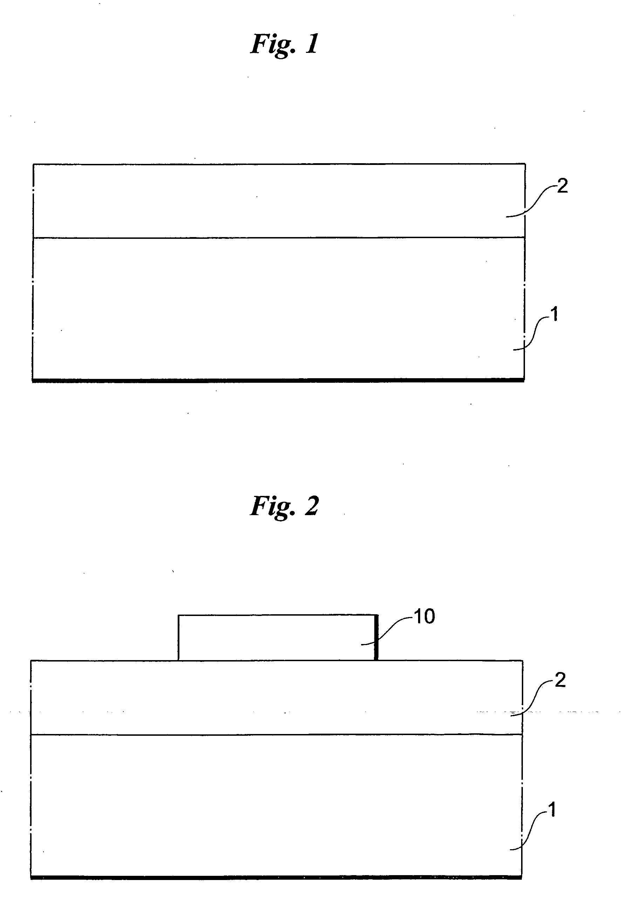

A method of manufacturing a field-effect transistor (FET) will be described in accordance with a first embodiment, and the structure of the FET fabricated by this manufacturing method will be made clear at the same time. Figs. 1 to 7 illustrate only a single FET on a glass substrate, although it goes without saying that a plurality or multiplicity of FETs can be constructed on a glass substrate as necessary.

In Fig. 1, an amorphous silicon film (an amorphous Si layer) or a polycrystalline silicon film (polycrystalline Si layer) 2 is formed on a glass substrate 1. In the case of amorphous Si, this is crystallized. For example, use is made of the metal-induced lateral crystallization method (the MILC method). Crystal growth of Si is possible at temperatures below 500°C.

Next, in Fig. 2, a mask 10 for forming a germanium layer (thin film) and also for ion implantation is formed on the polycrystalline Si layer 2 except in regions intended for a source and drain.

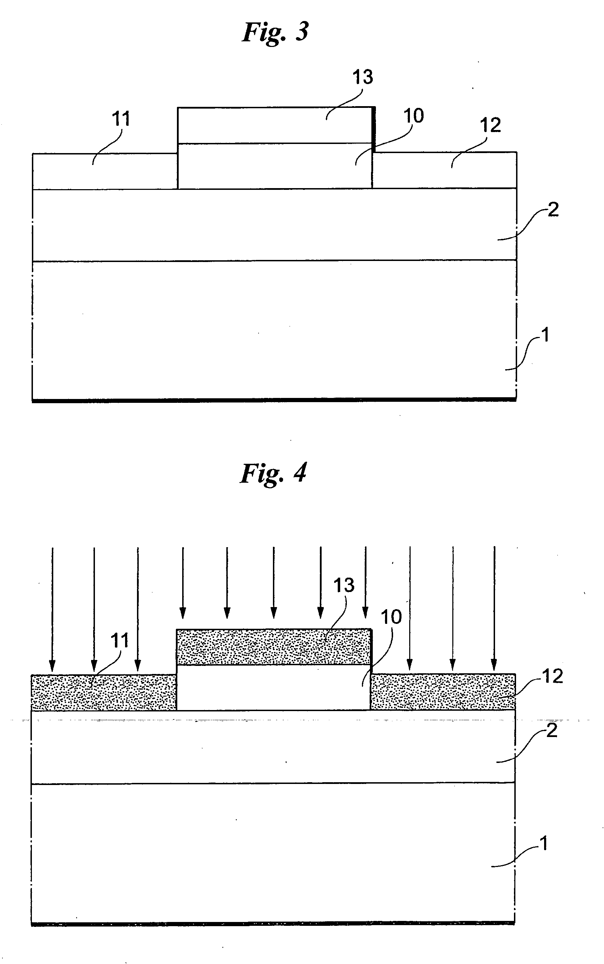

Next, in Fig. 3, germanium (Ge) layers 11, 12 are formed on the glass substrate 1 at the portions not covered by the mask 10 that are intended for a source and drain. Formation of the Ge layers 11, 12 can be performed by, e.g., vacuum deposition, as a result of which amorphous Ge is formed. A Ge layer 13 is formed on the mask 10 as well.

In Fig. 4, ions of a dopant (e.g., phosphorous) are implanted in the Ge layers 11, 12 (and 13) by ion implantation, etc. It may be so arranged that the dopant is implanted only in the Ge layers 11, 12 (and 13), or it may be so arranged that some of the dopant reaches the polycrystalline Si layer 2. In the case of the latter, the dosage adopted is of such a degree that the polycrystalline Si layer 2 will not be rendered amorphous.

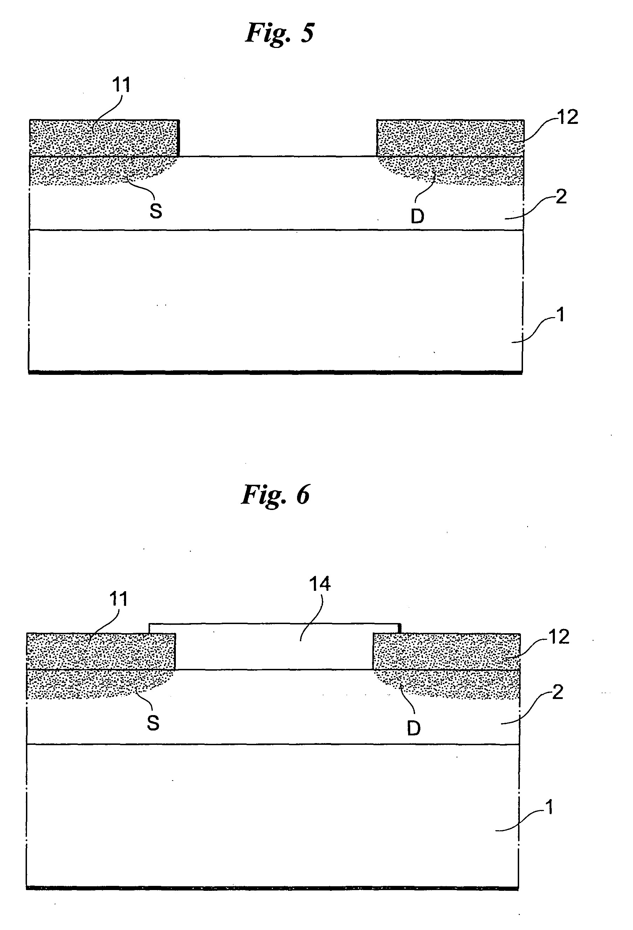

As illustrated in Fig. 5, the mask 11 (and Ge layer 13 thereon) is removed. The glass substrate 1 on which the polycrystalline Si layer 2 and Ge layers 11, 12 have been formed is placed in an oven, and annealing (heating) is applied in an atmosphere of N₂ or inert gas to activate the dopant and crystallize the Ge layers 11, 12. At this time the dopant diffuses into the polycrystalline Si layer 2, and a source region S and drain region D are formed beneath the Ge layers 11, 12, respectively. By applying annealing for 2 to 3 hours at a temperature in the neighborhood of 500°C, preferably below 505°C and, more preferably, below 500°C, it was found that the Ge layers 11, 12 polycrystallize and that the resistivity of the Ge layers 11, 12 declines greatly.

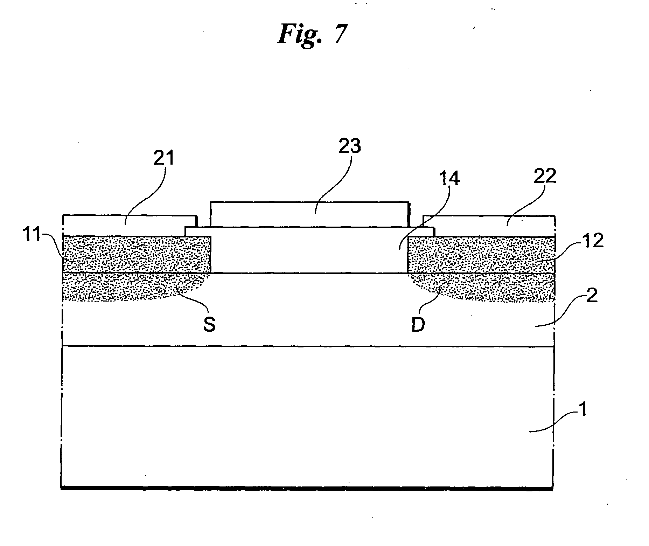

Finally, as shown in Fig. 6, an insulating film (layer) (a gate oxide film) 14 is formed on the region of the polycrystalline Si layer 2 that is to become a channel region between the source region S and drain region D. Furthermore, as illustrated in Fig. 7, a source electrode 21, drain electrode 22 and gate electrode 23 (electrode pad) are formed on the Ge layers 11, 12 and insulating film 14.

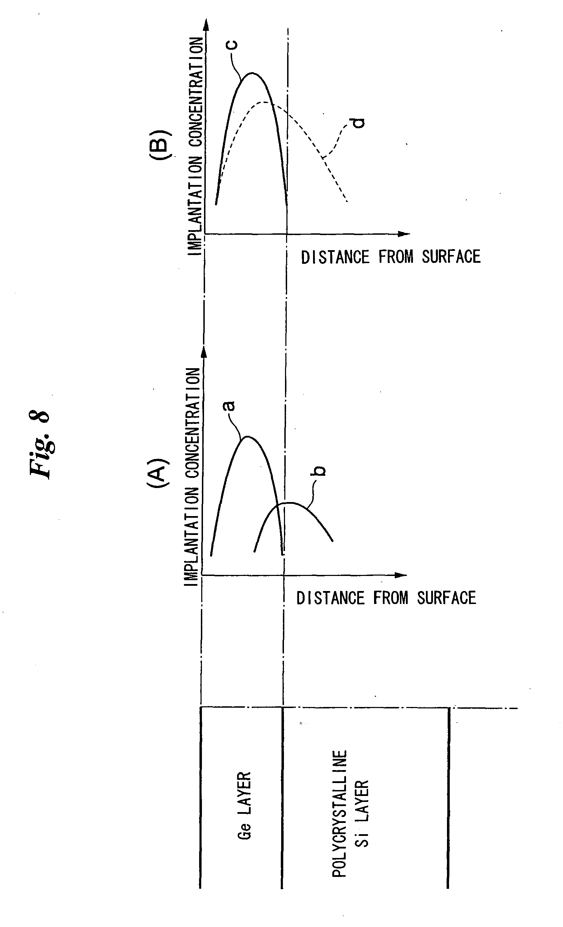

In the first embodiment set forth above, the ion implantation of the dopant basically is carried out with regard to the Ge layers 11, 12. The distribution of ion implantation concentration in the depth direction is indicated by curve c at (B) of Fig. 8. The dopant that has been implanted in the Ge layers 11, 12 is diffused into the polycrystalline Si layer 2 by annealing, and the distribution of the dopant is as indicated by the dashed line d. A comparatively long annealing time is required.

By contrast, a second embodiment is such that ion implantation is performed twice, as indicated at (A) in Fig. 8. In the first implantation, ions are injected at a high acceleration voltage in such a manner that the dopant ions are injected into the polycrystalline Si layer 2 (that is, the dopant is injected not only into the Ge layers 11, 12 but also into the boundary between the polycrystalline Si layer 2 and Ge layers and into the interior of the polycrystalline Si layer 2). At this time the dosage is suppressed so that the polycrystalline Si layer 2 will not become amorphous (i.e., the dosage is made less than a critical dosage at which the polycrystalline Si will be rendered amorphous).

In the second implantation, the acceleration voltage is lowered and the dopant ions are injected mainly into the Ge layers 11, 12 so as to obtain a distribution indicated by curve a at (A) in Fig. 8. A large amount of dopant (greater than the critical dosage) is injected (e.g., more than 10¹⁹).

Thus, the electrical resistance of the portions of the polycrystalline Si layer 2 that contact the Ge layers 11, 12 is lowered without causing the polycrystalline Si layer 2 to become amorphous, and a source region and drain region having a high impurity concentration can be formed in the Ge layers 11, 12 and inside the polycrystalline Si layer 2 in contact with the Ge layers. The fact that the Ge layers 11, 12 are crystallized and electrical resistance reduced by annealing is the same as in the first embodiment.

The first ion implantation (profile b) and the second ion implantation (profile a) may be reversed in order, and implantation may be performed by a single ion implantation in such a manner that the implantation will have a profile in which profiles a and b are superimposed.

In the second embodiment also it is possible that the dopant in the Ge layers 11, 12 will be injected into the polycrystalline Si layer 2 by the dopant diffusing effect of annealing, and this possibility is not excluded. In the first embodiment, it goes without saying that dopant ions may be injected not only into the Ge layers 11, 12 but also into the polycrystalline Si layer 2.

In the second embodiment, the steps preceding the ion implantation step (namely the formation of the polycrystalline Si layer 2, the formation of the mask 10 and the formation of the Ge layers 11, 12) are the same as in the first embodiment. Further, annealing at a temperature in the neighborhood of 500°C, preferably below 505°C and, more preferably, below 500°C after ion implantation is the same in the second embodiment. However, it will suffice if annealing crystallizes the Ge layers 11, 12. It goes without saying that formation of an insulating film and electrodes is carried out last.

## Claims

1. A method of manufacturing a field-effect transistor, comprising:
forming a polycrystalline silicon layer on a glass substrate;
forming a germanium layer selectively on said polycrystalline silicon layers in regions that are to become a source and a drain;
implanting ions, which serve as a dopant, at least into said germanium layers; and
subsequently causing the implanted dopant to diffuse into said polycrystalline silicon layer by annealing, thereby forming source and drain regions and crystallizing said germanium layer.

2. A method of manufacturing a field-effect transistor, comprising:
forming a polycrystalline silicon layer on a glass substrate;
forming germanium layers selectively on said polycrystalline silicon layer in regions that are to become a source and a drain;
implanting ions, which serve as a dopant, into said germanium layers, and implanting ions, so as to reach said polycrystalline silicon layer, at a dosage less than a critical dosage that will render said polycrystalline silicon layer amorphous; and
subsequently crystallizing said germanium layer by annealing.

3. A method of manufacturing a field-effect transistor according to claim 1 or 2, wherein said annealing is performed at a temperature below 505°C.

4. A method of manufacturing a field-effect transistor according to claim 1 or 2, wherein a germanium layer is vapor-deposited and ion implantation performed upon forming a mask on the polycrystalline silicon layer except in regions that are to be the source and drain, after which the mask is removed.

5. A field-effect transistor having:
a polycrystalline silicon layer formed on a glass substrate; and
germanium layers formed on said polycrystalline silicon layer in regions that are to become a source and a drain; and
wherein a source region and a drain region are formed by distributing a dopant in said germanium layers and at portions where said polycrystalline silicon layer contacts said germanium layers, and the germanium layers in which the dopant is distributed are formed by ion implantation of the dopant and crystallization by subsequent annealing.

6. A field-effect transistor according to claim 5, wherein the distribution of dopant within said polycrystalline silicon layer is based upon the fact that dopant implanted at least into the germanium layers is thermally diffused into said polycrystalline silicon layer.

7. A field-effect transistor according to claim 5, wherein the distribution of dopant within said polycrystalline silicon layer is based upon ion implantation at a dosage of such a degree that at least said polycrystalline silicon layer will not be rendered amorphous.
